# EUROPÄISCHE PATENTSCHRIFT

(11) **EP 2 162 282 B1**
(45) Veröffentlichungstag und Bekanntmachung des Hinweises auf die Patenterteilung: **09.10.2019**
(21) Anmeldenummer: 08773289.7
(22) Anmeldetag: 03.07.2008
(51) Int. Cl.: B32B 3/08, A41D 1/00, G06K 19/077

(54) **FLÄCHENVERKLEIDUNGSSTRUKTUR UND VERFAHREN ZUM HERSTELLEN EINER FLÄCHENVERKLEIDUNGSSTRUKTUR**
SURFACE-COVERING STRUCTURE AND METHOD FOR PRODUCING A SURFACE-COVERING STRUCTURE
STRUCTURE DE REVÊTEMENT DE SURFACE ET PROCÉDÉ POUR PRODUIRE UNE STRUCTURE DE REVÊTEMENT DE SURFACE

(30) Priorität: 03.07.2007 DE 102007030829
(43) Veröffentlichungstag der Anmeldung: 17.03.2010
(73) Patentinhaber: Lauterbach, Christl, 85635 Höhenkirchen-Siegertsbrunn (DE); Steinhage, Axel, 85614 Kirchseeon (DE)
(72) Erfinder: Lauterbach, Christl, 85635 Höhenkirchen-Siegertsbrunn (DE); Steinhage, Axel, 85614 Kirchseeon (DE)
(74) Vertreter: Viering, Jentschura & Partner mbB Patent- und Rechtsanwälte
(86) Internationale Anmeldenummer: PCT/DE2008/001109
(87) Internationale Veröffentlichungsnummer: WO 2009/003464

(56) Entgegenhaltungen:
- EP-A- 0 913 268
- WO-A-02/056657
- WO-A1-2005/071597
- DE-A1- 10 202 123
- DE-C1- 10 141 382
- US-A1- 2004 001 000
- US-A1- 2004 021 617

## Beschreibung

Die Erfindung betrifft eine Flächenverkleidungsstruktur und ein Verfahren zum Herstellen einer Flächenverkleidungsstruktur.

In den letzten Jahrzehnten wurden auf dem Gebiet der intelligenten Textilien viele Ideen verwirklicht. Im Zuge der weiter voranschreitenden Miniaturisierung von elektronischen Bauelementen wurde es zunehmend leichter, elektronische Chips so zu dimensionieren, dass sie auf Textilien aufgebracht oder in diese integriert werden konnten, ohne die Hauptfunktion der Textilien zu beeinträchtigen. Außerdem wurden die elektronischen Bauelemente immer kostengünstiger, so dass ihr Einsatz auch für Produkte im mittleren Preisbereich ermöglicht wurde.

Beispielsweise wurden auf dem Gebiet der interaktiven Kleidungstextilien elektronische Einheiten verwendet, um den Trägern der interaktiven Kleidung zusätzliche Funktionen oder Informationen zu liefern.

Ein besonders interessantes Gebiet der Anwendung von integrierten elektronischen Bauelementen ist das Gebiet der Ambient Intelligence, wobei elektronische Sensoren/Aktoren und oder Sende/Empfangseinheiten in Raumausstattungsobjekte integriert sind und dem Benutzer durch Sammeln und Verarbeiten von Daten Informationen zur Verfügung stellen oder für ihn Funktionen ausführen, ohne dass seine aktive Mitarbeit benötigt wird bzw. der Benutzer die Funktionsweise von Bedienelementen verstehen muss, vgl. US2004021617 A1 (Bodenbelag mit integriertem Display) oder WO2005071597 A1 (Bodenbelag mit eingebettetem RFID Modul).

Die Integration der genannten elektronischen Bauelemente in Flächenverkleidungsstrukturen, wie zum Beispiel Bodenbeläge, bereitet jedoch erhebliche Probleme.

Insbesondere bei Bodenbelägen, welche bei ihrer Begehung hohen mechanischen Belastungen ausgesetzt sind, sind die elektronischen Bauelemente oft nicht ausreichend gegen mechanische Belastungen geschützt, so dass sie diesen mechanischen Belastungen nicht standhalten.

Ferner sollten auch optische Anforderungen erfüllt werden.

Bei vielen Sensoranordnungen wird jedoch die Oberflächenstruktur der Bodenbeläge durch die elektronischen Bauelemente beidseitig unterbrochen bzw. durchbrochen, so dass die äußere Erscheinung der Bodenbeläge beeinträchtigt ist.

Außerdem ist bei der Integration der mikroelektronischen Bauelemente in Flächenverkleidungsstrukturen oft nicht gewährleistet, dass die mikroelektronischen Bauelemente auch gegen thermische oder andere physikalische oder chemische Belastungen geschützt sind.

In vielen Fällen waren die Verfahren zur Integration der Elektronikmodule in Flächenverkleidungsstrukturen auch nicht für die Massenproduktion geeignet.

Das gewünschte Verfahren zum Herstellen von Flächenverkleidungsstrukturen mit integrierten Elektronikmodulen sollte auch im Rahmen von zur Massenproduktion geeigneten Verfahren wie zum Beispiel eines Rolle-zu-Rolle-Prozesses realisiert werden können.

In [1] wird ein elektronisches Bauelement beschrieben, dessen Kontakte mit draht- oder fadenartigen Leitern verbunden sind, die in einem textilen Material angeordnet sind.

In [2] wird ein Bodenbelagelement mit einer Beleuchtungsanordnung beschrieben, wobei die Beleuchtungsanordnung aus einer Vielzahl von elektrischen Leuchtelementen besteht, die entweder in dem Bodenbelagelement oder in einer an der Unterseite des Bodenbelagelements angeordneten Unterlage angeordnet sind.

In [3] wird ein Lichtleit- und Orientierungselement beschrieben, das in eine Bauplatte integriert ist.

In [4] wird eine Blinkleuchte zum Markieren von Fahrbahnen und anderen Objekten im Straßenverkehr beschrieben, die in einem in den Bauwerkstoff direkt eingebetteten Gehäuse angeordnet ist.

In [5] wird eine Erfasseinrichtung mit Sensoren beschrieben, die in einen Bodenbelag integriert ist. Die Einrichtung wird mit Batterie betrieben.

In [6] wird eine Wägevorrichtung beschrieben, wobei ein Wägeelement in ein Bodenbelagselement unterhalb der Bodenbelagsoberfläche integriert ist.

In [7] sind Leuchtelemente in Aussparungen eines Straßenbelags integriert, wobei die Aussparungen mit einem Füllmaterial aufgefüllt sind, so dass eine ebene Oberfläche oberhalb der Leuchtelemente entsteht.

Der Erfindung liegt das Problem zugrunde, eine Flächenverkleidungsstruktur mit integrierten Elektronikmodulen und ein Verfahren zum Herstellen der genannten Flächenverkleidungsstruktur bereitzustellen, welche die vorgenannten, bekannten Nachteile zumindest teilweise umgehen bzw. vermeiden.

Das Problem wird durch eine Flächenverkleidungsstruktur mit integriertem Elektronikmodul und ein Verfahren zum Herstellen derselben gelöst.

Beispielhafte Ausgestaltungen der Erfindung ergeben sich aus den abhängigen Patentansprüchen. Die weiteren Ausgestaltungen der Erfindung, die im Zusammenhang mit der Flächenverkleidungsstruktur beschrieben sind, gelten sinngemäß auch für das Verfahren zu dessen Herstellung.

Gemäß einem Ausführungsbeispiel der Erfindung wird eine Flächenverkleidungsstruktur bereitgestellt mit einer ersten Schicht, mit einer Vertiefung in der ersten Schicht, und mit mindestens einem Elektronikmodul in der Vertiefung, mit einer zweiten Schicht auf dem mindestens einen Elektronikmodul, welche zweite Schicht der ersten Schicht gegenüberliegt und das Elektronikmodul abdeckt, wobei die zweite Schicht auf dem mindestens einen Elektronikmodul die Vertiefung zumindest teilweise auffüllt, so dass das mindestens eine Elektronikmodul von der zweiten Schicht bedeckt ist, wobei das Material der ersten Schicht und/oder der zweiten Schicht ein Textil oder ein Schaumstoff ist.

Gemäß einem anderen Ausführungsbeispiel der Erfindung wird ein Verfahren zum Herstellen einer Flächenverkleidungsstruktur bereitgestellt, bei dem in einer ersten Schicht eine Vertiefung eingebracht wird, und bei dem mindestens ein Elektronikmodul in der Vertiefung angeordnet wird, bei dem eine zweite Schicht auf dem mindestens einen Elektronikmodul aufgebracht wird, welche zweite Schicht der ersten Schicht gegenüberliegt, wobei die zweite Schicht derart auf dem mindestens einen Elektronikmodul aufgebracht wird, dass sie die Vertiefung zumindest teilweise auffüllt, so dass das mindestens eine Elektronikmodul von der zweiten Schicht bedeckt ist, wobei als Material für die erste Schicht und/oder für die zweite Schicht Textil oder Schaumstoff verwendet wird.

Ein Aspekt der Erfindung kann darin gesehen werden, dass passive oder aktive Elektronikmodule in eine Flächenverkleidungsstruktur integriert und verkapselt werden können. Hierbei wird beispielsweise der Bereich unterhalb des Elektronikmoduls mechanisch versteift und verdichtet,(beispielsweise durch das Eindrücken der Vertiefung) und so entsteht ein zusätzlicher Schutz für das Elektronikmodul.

Ist die Temperatur zum Eindrücken einer Vertiefung in ein Basismaterial niedriger als die maximale Temperatur, die das Elektronikmodul unbeschadet übersteht, kann die Vertiefung auch direkt durch Aufheizen und Eindrücken des Elektronikmoduls realisiert werden.

Gemäß der oben genannten Ausgestaltung der Erfindung ist eine zweite Schicht (die anschaulich eine Füllschicht, Deckschicht, oder auch Schutzschicht darstellt) auf dem mindestens einen Elektronikmodul vorgesehen, welche zweite Schicht der ersten Schicht gegenüberliegt und das Elektronikmodul abdeckt.

Die Vertiefung ist von der Schicht vollständig aufgefüllt. Somit entsteht eine Anordnung mit auch im Bereich des Elektronikmoduls bzw. der Elektronikmodule planarer Auflagefläche, welche somit im diesem Bereich eine mechanisch stabilisierende Wirkung hat.

Die Schicht besteht aus einer Vergussmasse oder weist eine Vergussmasse auf.

Die Verwendung einer Vergussmasse als Schichtmaterial ermöglicht die besonders einfache Anpassung der Schicht an die Form der Vertiefung und erleichtert die Herstellung der integrierten Struktur.

Es ist eine elektrisch leitfähige Bahn oder sind elektrisch leitfähige Bahnen auf der ersten Schicht angeordnet, die das mindestens eine Elektronikmodul kontaktieren.

Handelt es sich bei dem mindestens einen Elektronikmodul um ein aktives Elektronikmodul, so kann eine äußere Stromversorgung des mindestens einen Elektronikmoduls notwendig sein, welche mittels der elektrisch leitfähigen Bahnen gewährleistet wird.

Außerdem können mittels der elektrisch leitfähigen Bahnen die einzelnen Elektronikmodule miteinander elektrisch verbunden werden, so dass ein Informationsaustausch zwischen den einzelnen Elektronikmodulen ermöglicht wird.

In einer alternativen Ausgestaltung der Erfindung sind die elektrisch leitfähigen Bahnen auf der zweiten Schicht angeordnet.

In diesem Fall müssen die elektrisch leitfähigen Bahnen im Bereich der Elektronikmodule nicht in der Vertiefung verlaufen und zum Beispiel gekrümmt werden, sondern sie können in einer Ebene angeordnet sein.

In einer noch anderen Ausgestaltung der Erfindung ist das mindestens eine Elektronikmodul auf der mindestens einen elektrisch leitfähigen Bahn angeordnet, so dass es diese kontaktiert.

In einer Ausgestaltung der Erfindung ist der Bereich, in dem das mindestens eine Elektronikmodul aufgebracht ist, bis auf die Kontaktbereiche zwischen dem Elektronikmodul und den elektrisch leitfähigen Bahnen von der mindestens einen elektrisch leitfähigen Bahn frei.

Auf diese Weise wird gewährleistet, dass das mindestens eine Elektronikmodul nur in den dafür vorgesehenen Kontaktbereichen elektrisch kontaktiert wird.

In einer weiteren Ausgestaltung der Erfindung weist die erste Schicht unterhalb der Vertiefung einen Bereich mit verdichtetem Material auf.

Die Verdichtung des Materials der ersten Schicht bewirkt eine verbesserte Widerstandsfähigkeit der Flächenverkleidungsstruktur im Bereich des mindestens einen Elektronikmoduls gegen beispielsweise mechanische, thermische oder andere physikalische oder chemische Belastungen.

In einer anderen Ausgestaltung der Erfindung ist das mindestens eine Elektronikmodul mit einem Klebematerial in der Vertiefung eingeklebt.

In einer speziellen Ausgestaltung der Erfindung ist das Elektronikmodul mit einem elektrisch nichtleitfähigen (isolierenden) Klebmaterial oder mit einem anisotrop leitfähigen Klebematerial in der Vertiefung eingeklebt.

In noch einer anderen Ausgestaltung der Erfindung weist das Elektronikmodul elektrische Kontakte auf, die auf den elektrisch leitfähigen Bahnen angeordnet sind, so dass diese die elektrischen Kontakte kontaktieren.

In einer speziellen Ausgestaltung der Erfindung besteht die erste Schicht aus einem Material, das elektrisch isolierend ist, oder weist ein solches Material auf.

Somit wird das mindestens eine Elektronikmodul zum Beispiel gegen eine Auflagefläche elektrisch isoliert.

In einer anderen Ausgestaltung der Erfindung ist auf der Seite der Flächenverkleidungsstruktur, die der die Vertiefung aufweisenden Seite gegenüberliegt, eine Schutzschicht aufgebracht, die eine wasserfeste Schicht sein kann.

Somit kann das Basismaterial und das mindestens eine Elektronikmodul vor Beschädigung durch Wassereinbruch geschützt werden.

In einer weiteren Ausgestaltung der Erfindung ist das Material der ersten und/oder der zweiten Schicht porös.

Ein solches Material eignet sich für besonders leichte, Flüssigkeiten absorbierende Flächenverkleidungselemente.

In einer anderen Ausgestaltung der Erfindung wird bei der Herstellung der Flächenverkleidungsstruktur die Vertiefung unter erhöhter Temperatur in die erste Schicht eingebracht.

Mittels Ausübens von Druck wird die gewünschte Vertiefung erzielt, während mit der Erhöhung der Temperatur die Form der Vertiefung fixiert wird und so verhindert wird, dass sich die Vertiefung nach Beendigung der Druckphase und nach erfolgter Abkühlung wieder zurückbildet.

Die Tiefe der Mulde, die über die Dicke des eingebauten Moduls hinausgeht, gibt die Möglichkeit, das Modul durch eine Vergussmasse elektrisch zu isolieren und vor mechanischen Belastungen und Feuchtigkeit zu schützen.

In einer Ausgestaltung der Erfindung wird die Vertiefung mittels eines Stempels erzeugt.

Eine solche Vorgehensweise lässt sich besonders einfach realisieren und ist auch zur Verwendung in der Serienproduktion geeignet.

In einer besonderen Ausgestaltung der Erfindung wird als Stempel ein Körper in der Form eines Kegel- oder Pyramidenstumpfes verwendet, so dass möglichst flach auslaufende Kanten der Vertiefung erzeugt werden.

Flach auslaufende Kanten an den Rändern der Vertiefung verhindern ein zu starkes Knicken beispielsweise von elektrisch leitenden Bahnen, so dass die mechanische Belastung bei der Herstellun und im Gebrauch gering gehalten wird wird und die Aufrechterhaltung der elektrischen Leitfähigkeit der elektrisch leitenden Bahnen gewährleistet wird.

Die Vertiefung kann mittels Fräsens, Prägens, Laserns oder Ätzens erzeugt werden.

Die Vertiefung wird vollständig mit einem Füllmaterial aufgefüllt, so dass die Flächenverkleidungsstruktur auf der Seite der Vertiefung eine planare Oberfläche aufweist.

Gemäß einer anderen Ausgestaltung der Erfindung wird das Elektronikmodul auf der ersten Schicht und/oder der zweiten Schicht mittels eines Klebematerials fixiert.

Gemäß einer weiteren Ausgestaltung der Erfindung wird als Klebematerial ein elektrisch nicht leitfähiges oder ein anisotrop leitfähiges Material verwendet.

Das Klebematerial kann auch zur Erzeugung einer Verbindung zwischen einem Kontaktpad auf dem Elektronikmodul und den elektrisch leitenden Bahnen verwendet werden, wobei es vorzugsweise anisotrop leitfähig ist, so dass es das Elektronikmodul ganzflächig mit der ersten Schicht als Unterlage verklebt und im Bereich des Kontaktpads eine elektrisch leitfähige Verbindung mit den elektrisch leitenden Bahnen erzeugt.

Bei einer alternativen Ausgestaltung der Erfindung wird als Klebematerial das durch die Temperaturerhöhung bei der Bildung der Vertiefung erwärmte Material der ersten und oder der zweiten Schicht verwendet.

Somit kann auf ein zusätzliches Klebematerial zur Fixierung des Elektronikmoduls auf der ersten und/oder der zweiten Schicht verzichtet werden.

Es wird mindestens eine elektrisch leitfähige Bahn auf der ersten Schicht und/oder der zweiten Schicht aufgebracht.

Die mindestens eine elektrisch leitfähigen Bahn lässt sich zum Stromtransport zu den Elektronikmodulen oder für den Datenaustausch zwischen den einzelnen Elektronikmodulen verwenden.

In einer anderen Ausgestaltung der Erfindung wird das mindestens eine Elektronikmodul derart auf der mindestens einen elektrisch leitfähigen Bahn angeordnet, dass es die mindestens eine elektrisch leitfähige Bahn kontaktiert.

Somit wird eine Stromversorgung des mindestens einen Elektronikmoduls ermöglicht.

Das Herstellen des Kontakts kann mittels Laserschweißen, Ultraschallbonden, Kleben mit leitfähigen, nichtleitfähigen oder anisotrop leitfähigen Klebern geschehen.

Somit ist ein sicherer und zuverlässiger elektrischer Kontakt zwischen dem mindestens einen Elektronikmodul und den elektrisch leitfähigen Bahnen gewährleistet, welcher auch beispielsweise mechanischen Belastungen standhalten kann.

In einer weiteren Ausgestaltung der Erfindung wird beim Aufbringen der zweiten Schicht die mindestens eine elektrisch leitfähige Bahn passiviert.

Somit wird die mindestens eine elektrisch leitfähige Bahn gegen Kurzschlüsse oder Kriechströme z.B. Nässe geschützt.

In noch einer weiteren Ausgestaltung der Erfindung wird beim Aufbringen der zweiten Schicht ein Bereich der ersten Schicht freigelassen, so dass ein Teil der mindestens einen elektrisch leitfähigen Bahn unpassiviert bleibt.

Hiermit wird eine Kontaktierung der elektrisch leitfähigen Bahnen in dem Abschnitt, in dem sie unpassiviert bleiben, ermöglicht.

Gemäß einer alternativen Ausgestaltung der Erfindung wird beim Aufbringen der mindestens einen elektrisch leitfähigen Bahn der Bereich, in dem das mindestens eine Elektronikmodul aufgebracht wird, ausgespart.

In einer noch anderen Ausgestaltung der Erfindung wird die Schicht über der gesamten ersten Schicht aufgebracht, so dass auf der Seite der Schicht eine planare Oberfläche entsteht.

In diesem Fall besteht die gesamte Auflagefläche aus einer planaren homogenen Oberfläche, welche eine besonders große Widerstandsfähigkeit der gesamten Flächenverkleidungsstruktur ermöglicht.

In einer alternativen Ausgestaltung der Erfindung wird beim Aufbringen der zweiten Schicht diese Schicht außerhalb des Bereichs der Vertiefung so dünn gehalten, dass die Flächenverkleidungsstruktur ausreichend elastisch bleibt.

Durch diese Vorgehensweise wird die Flächenverkleidungsstruktur ausreichend elastisch gehalten, so dass sie hinreichend rollfähig'bleibt, was zum Beispiel bei der Verwendung als Teppichboden erwünscht ist.

Gemäß einer anderen Ausgestaltung der Erfindung wird die zweite Schicht nur im Bereich der Vertiefung aufgebracht.

Somit bleibt die Verwendung der zweiten Schicht auf den Bereich des mindestens einen Elektronikmoduls beschränkt, so dass der größte Teil der Auflagefläche der Flächenverkleidungsstruktur von der ersten Schicht gebildet wird.

Gemäß einer weiteren Ausgestaltung der Erfindung wird die Flächenverkleidungsstruktur so angeordnet, dass die Seite mit dem mindestens einen Elektronikmodul in Richtung Boden zeigt.

Durch diese Maßnahme ist das mindestens eine Elektronikmodul vor mechanischen, thermischen oder anderen physikalischen oder chemischen Belastungen, welche von der Oberseite der Flächenverkleidungsstruktur herrühren, gut geschützt

In einer anderen Ausgestaltung der Erfindung werden die Herstellungsschritte im Rahmen eines Rolle-zu-Rolle-Verfahrens durchgeführt.

Dies erlaubt die preiswerte serienmäßige Herstellung von großflächigen Strukturen.

Alternativ kann auf der Seite der Flächenverkleidungsstruktur, die der die Vertiefung aufweisenden Seite gegenüberliegt, eine Schutzschicht aufgebracht werden.

Das Aufbringen einer derartigen Schutzschicht ergibt einen zusätzlichen Schutz der Flächenverkleidungsstruktur gegenüber physikalischen oder chemischen Belastungen.

Gemäß einer alternativen Ausgestaltung der Erfindung wird als Schutzschicht eine wasserfeste Schicht aufgebracht.

Somit kann das gesamte System vor Nässe geschützt werden und so auch unter widrigeren Bedingungen eingesetzt werden.

In einer speziellen Ausgestaltung der Erfindung wird als Material für die erste und/oder die zweite Schicht poröses Material verwendet.

Hiermit lassen sich besonders leichte und Feuchtigkeit absorbierende Strukturen erzielen.

Ausführungsbeispiele der Erfindung sind in den Figuren dargestellt und werden im Folgenden näher erläutert. In den Figuren sind gleiche oder ähnliche Elemente, soweit sinnvoll, mit gleichen oder identischen Bezugszeichen versehen. Die in den Figuren gezeigten Darstellungen sind schematisch und daher nicht maßstabsgetreu gezeichnet.

Es zeigen
die Figuren 1A bis 1C ein Verfahren zum Herstellen einer Flächenverkleidungsstruktur gemäß einem ersten Ausführungsbeispiel der Erfindung;
die Figuren 2A bis 2C ein Verfahren zum Herstellen einer Flächenverkleidungsstruktur gemäß einem zweiten Ausführungsbeispiel der Erfindung;
Figuren 3A eine Flächenverkleidungsstruktur gemäß einem dritten Ausführungsbeispiel der Erfindung
Figur 4 die Anordnung einer Flächenverkleidungsstruktur gemäß dem dritten Ausführungsbeispiel der Erfindung;
die Figuren 5A bis 5B ein vereinfachtes Verfahren zum Herstellen einer Flächenverkleidungsstruktur gemäß einem vierten Ausführungsbeispiel der Erfindung;
Figur 6 eine Flächenverkleidungsstruktur gemäß einem fünften Ausführungsbeispiel der Erfindung;
Figur 7 eine Flächenverkleidungsstruktur gemäß einem sechsten Ausführungsbeispiel der Erfindung.

Im Rahmen dieser Beschreibung werden die Begriffe "verbunden", "angeschlossen" sowie "gekoppelt" verwendet zum Beschreiben sowohl einer direkten als auch einer indirekten Verbindung, eines direkten oder indirekten Anschlusses sowie einer direkten oder indirekten Kopplung. In den Figuren werden identische oder ähnliche Elemente mit identischen Bezugszeichen versehen, soweit dies zweckmäßig ist.

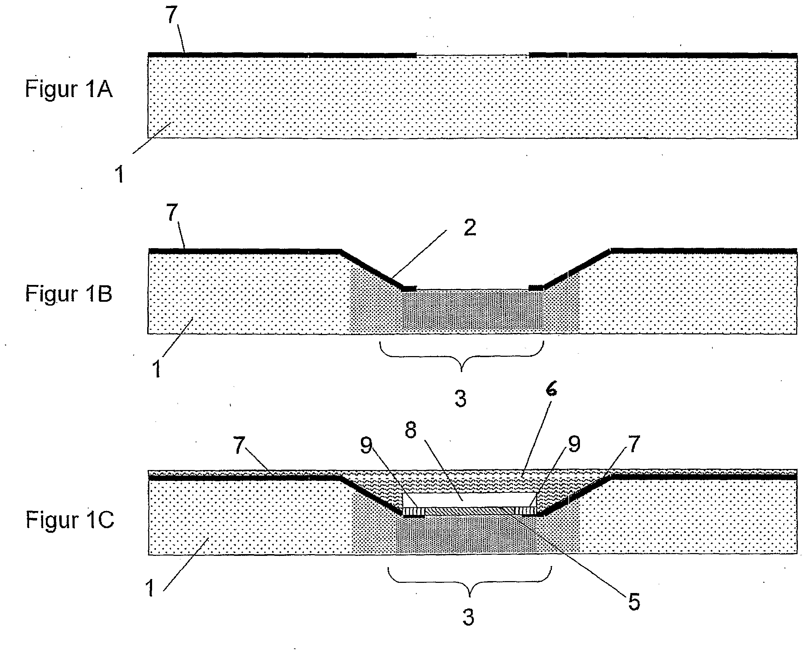

In den **Figuren 1A bis 1C** wird die Herstellung einer Flächenverkleidungsstruktur 0 gemäß einem ersten Ausführungsbeispiel der Erfindung gezeigt.

**Fig. 1A** zeigt eine erste Basisschicht 1, welche auch als erste Schicht 1 bezeichnet wird, mit aufgebrachten elektrisch leitfähigen Bahnen 7, wobei die leitfähigen Bahnen an der späteren Einbaustelle ausgespart sind. Allerdings werden sie soweit in den Bereich der spätern Einbaustelle hineingeführt, dass sie bei der späteren Montage des Elektronikmoduls unterhalb von den Anschlusspads 9 verlaufen und dort elektrisch kontaktiert werden können. Die elektrisch leitfähigen Bahnen 7 können beispielsweise Gewebe mit eingewobenen Metalllitzen oder Textilien mit elektrisch leitfähigen Bereichen aufweisen.

In **Fig. 1B** wird zunächst eine Vertiefung 2 in der Basisschicht 1 ausgebildet. Dies kann beispielsweise erfolgen mittels Eindrückens eines Stempels in das Basismaterial 1, welches beispielsweise Vliese aus Polyester, Polypropylen, Polyamid oder Schäume aus Polyethylen, Polyurethan aufweisen kann, beispielsweise bei Raumtemperatur, alternativ bei erhöhter Temperatur, beispielsweise bei einer Temperatur in einem Bereich von 120 °C bis 350 °C. Dadurch entsteht unterhalb der Vertiefung 2 ein verdichteter Bereich 3, in dem das Basismaterial zusammengepresst ist, was zu einer zusätzlichen Stabilität des Bereichs der Vertiefung 2 führt.

In **Fig. 1C** wird in dieser Vertiefung 2 ein Elektronikmodul 4 mit einem nichtleitfähigen Klebematerial 5, beispielsweise einem Copolymer, Silicon, Polyurethan, Epoxidharz oder PVC, eingeklebt, so dass die Anschlusspads 9 des Elektronikmoduls 8 mit den elektrisch leitfähigen Bahnen kontaktieren. Dann wird das Elektronikmodul mit einem Verkapselungsmaterial 6, beispielsweise einem Copolymer, Polyurethan, Silikon, PVC oder Epoxidharz so überzogen, dass über dem Elektronikmodul ein Höhenausgleich stattfindet, während in der übrigen Fläche die Verkapselungsschicht 6 so dünn gehalten wird, dass das Basismaterial 1 mit integriertem Modul noch rollfähig bleibt und keine Risse entstehen. Die elektrisch leitfähigen Bahnen 7 werden mittels der zweiten Schicht (Verkapselungsschicht) 6 passiviert.

Bei rein passiven Elektronikmodulen ist unter Umständen auch die alleinige Verkapselung des Moduls in der Vertiefung 2 ausreichend und es kann in diesem Spezialfall auf eine Verkapselung der Oberfläche verzichtet werden.

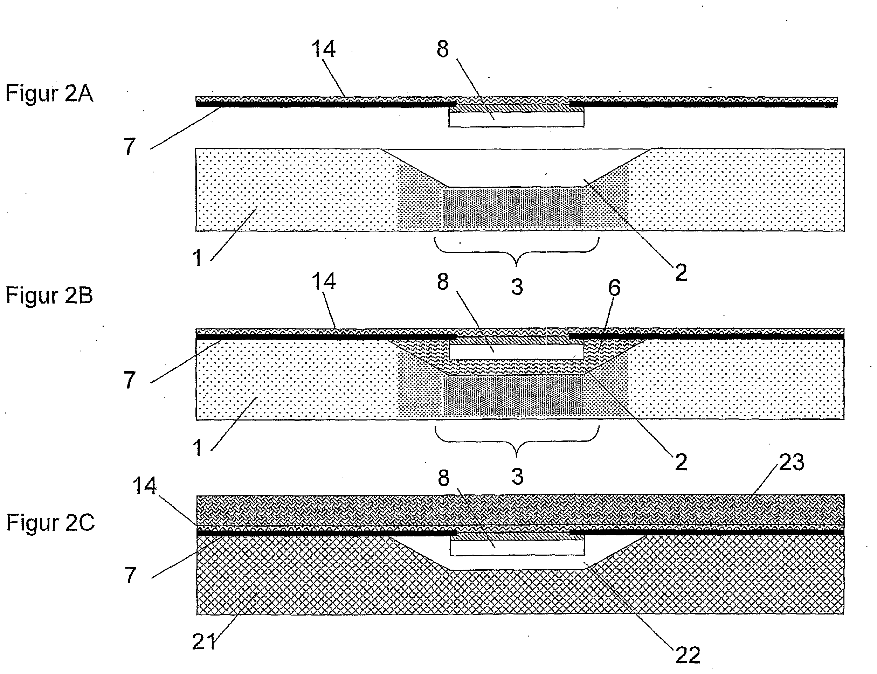

**Figur 2** zeigt ein Verfahren zum Herstellen einer Flächenverkleidungsstruktur 0 gemäß einem zweiten Ausführungsbeispiel der Erfindung.

Ähnlich dem ersten Ausführungsbeispiel wird, wie in **Fig. 2A** gezeigt, in eine erste Schicht 1 eine Vertiefung 2 eingebracht, welche einen verdichteten Bereich 3 aufweist. Im zweiten Ausführungsbeispiel weist die erste Schicht 1 jedoch im Gegensatz zu dem ersten Ausführungsbeispiel keine elektrisch leitfähigen Bahnen 7 auf. Anders als im ersten Ausführungsbeispiel werden im zweiten Ausführungsbeispiel auf einer zweiten Schicht 14 elektrische Bahnen 7 aufgebracht, wobei der Bereich, in dem ein Elektronikmodul 8 aufgebracht werden soll, ausgespart wird. Im Gegensatz zu dem ersten Ausführungsbeispiel dient im zweiten Ausführungsbeispiel die zweite Schicht also als Trägermaterial für eine Elektronikverdrahtung der elektrisch leitfähigen Bahnen 7. Anschließend wird das Elektronikmodul 8 auf den ausgesparten Bereich aufgebracht, und zwar so, dass es die leitfähigen Bahnen elektrisch kontaktiert.

Wie in **Figur 2B** gezeigt, wird im darauf folgenden Schritt die erste Schicht 1 mit der zweiten Schicht 14 verbunden, und zwar so, dass das Elektronikmodul 8 in der Vertiefung 2 angeordnet ist, wobei ein verbleibender Hohlraum der Vertiefung 2 zusätzlich aufgefüllt wird, um dem Bereich mit dem Elektronikmodul 8 erhöhte Stabilität zu verleihen.

Wie in **Figur 2C** gezeigt, kann auch auf eine Auffüllung des Hohlraums zwischen dem Elektronikmodul 8 und der Vertiefung 2 verzichtet werden, wenn auf der zweiten Schicht 14 zusätzlich eine mechanisch stabile dritte Schicht 23 als Deckfläche, bzw. Lauffläche, aufgebracht wird oder die zweite Schicht 14 selbst schon mechanisch stabil ist. Dies gilt insbesondere dann, wenn die erste Schicht 21, welche aus nicht thermoplastischem nichtleitfähigen Basismaterial bestehen kann, mit der Vertiefung 22, welche in diesem Fall mechanisch ausgearbeitet ist, selbst als mechanisch stabile Schicht ausgeführt ist, wobei in diesem Fall bei der Herstellung der Vertiefung auch kein verdichteter Bereich erzeugt wird.

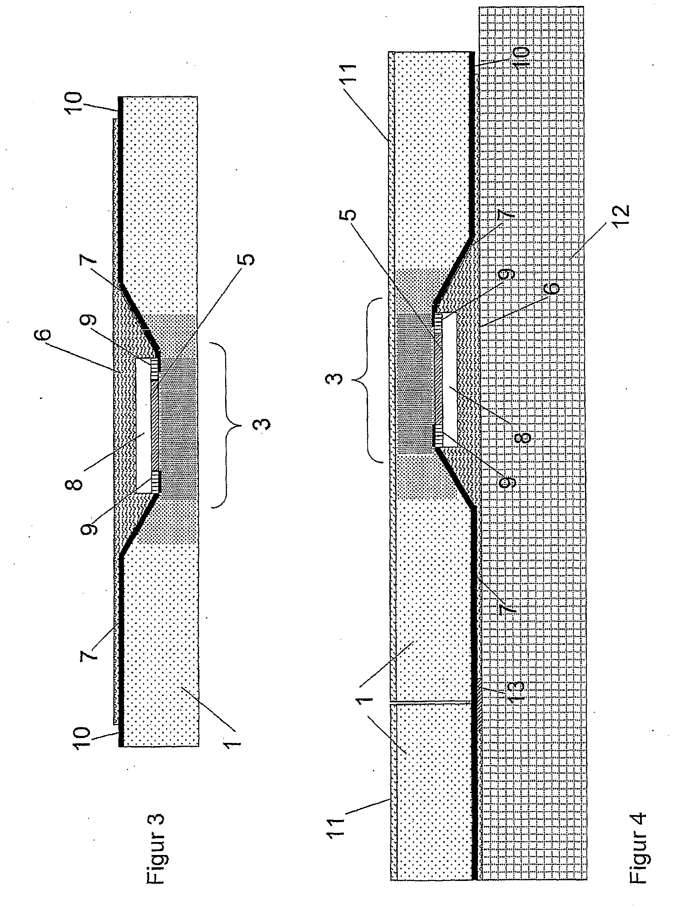

Die **Figur 3** zeigt eine Flächenverkleidungsstruktur 0 mit integriertem Elektronikmodul gemäß einem dritten Ausführungsbeispiel der Erfindung.

In diesem speziellen dritten Ausführungsbeispiel wird am Rand der Flächenverkleidungsstruktur ein Streifen unpassiviert gelassen, um an dieser Stelle die elektrisch leitfähigen Bahnen untereinander leicht elektrisch verbinden zu können. Dies kann z.B. durch das Aufbringen eines elektrisch leitfähigen Selbstklebebandes erfolgen.

In **Fig.4** wird die Installation einer Flächenverkleidungsstruktur auf einer Unterlage 12, z.B. einem Fußboden, gezeigt, wobei die einzelnen elektrisch leitfähigen Bahnen 7 aneinander gelegt werden und durch ein elektrisch leitfähiges Klebeband 13 an den zuvor bei der Verkapselung ausgesparten Bereichen 10 miteinander elektrisch verbunden werden. Optional können die einzelnen Bahnen auch an der Oberfläche wasserfest verklebt werden.

Somit lässt sich zum Beispiel ein System von Modulen mit Sensoren aufbauen, welche die Flächenverkleidungsstruktur als Sensorfläche nutzen, wobei die Module Informationen untereinander austauschen.

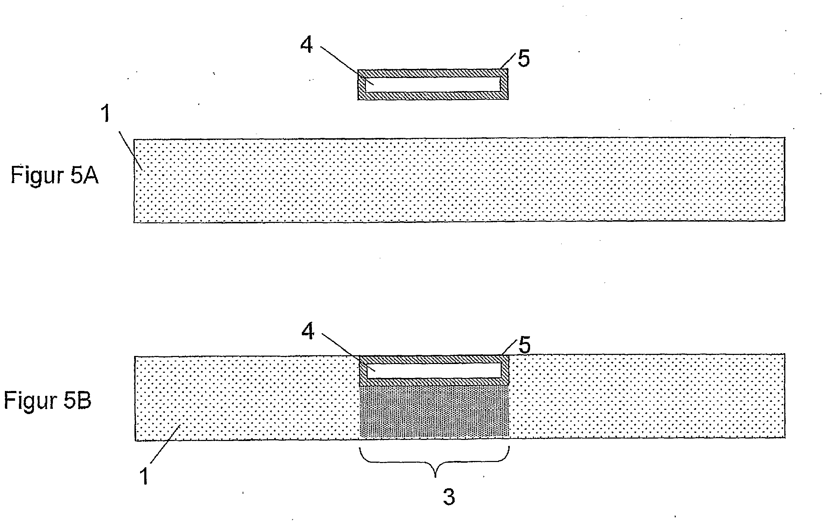

Die **Figuren 5A und 5B** zeigen ein vereinfachtes Verfahren zur Integration eines Elektronikmoduls 4 in das Basismaterial 1 gemäß einem vierten Ausführungsbeispiel der Erfindung. Hierbei ist das Elektronikmodul komplett von einer thermoplastischen Klebeschicht 5 umgeben, die gleichzeitig auch als Verkapselung dient. Unter Druck und Temperatur wird das Modul in das Basismaterial 1 so eingepresst, dass eine planare Oberfläche entsteht. Die für den Einbau des Moduls notwendige Vertiefung wird durch die Kompression des Basismaterials 1 gewonnen.

Dieses Verfahren lässt sich zum Beispiel bei der Verwendung von passiven Elektronikmodulen, die keine Stromversorgung brauchen, in Flächenverkleidungsstrukturen besonders kostengünstig einsetzen. Beispielsweise können passive RFID-Chips in die Flächenverkleidungsstrukturen integriert sein, die von aktiven RFID-Einrichtungen, die beispielsweise an mobilen Objekten angebracht sind, angefunkt werden, was zum Beispiel zur Positionsbestimmung der mobilen Objekte nützlich ist.

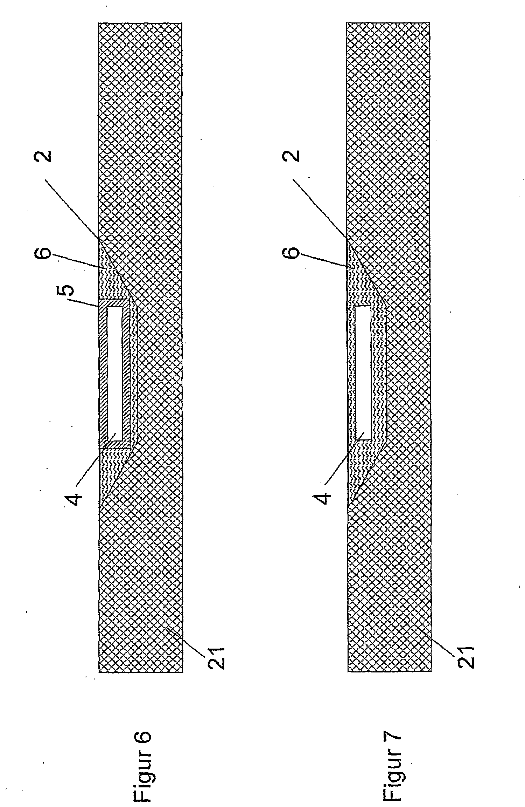

In **Figur 6** ist eine alternative Anordnungsmöglichkeit des in den Figuren 5A und 5B gezeigten passiven Elektronikmoduls gemäß einem fünften Ausführungsbeispiel der Erfindung gezeigt, wobei hierzu in die erste Schicht 1 eine Vertiefung 2 beispielsweise mechanisch eingebracht wird, ohne dass dabei ein verdichteter Bereich entsteht, und anschließend die Vertiefung 2 mit einem Füllmaterial 6 aufgefüllt wird und das passive mit einer Klebeschicht 5 umgebene Elektronikmodul 4 in die Vertiefung 2 mit der noch flüssigen Füllmasse 6 derart eingebracht wird, dass die Flächenverkleidungsstruktur auf der Seite der Vertiefung 2 eine planare Oberfläche aufweist.

**Figur 7** zeigt noch eine andere Anordnungsmöglichkeit gemäß einem sechsten Ausführungsbeispiel der Erfindung, welche der Anordnung in Figur 6 ähnelt, wobei die Klebeschicht 5 des Elektronikmoduls 4 vollständig weggelassen ist und das Modul 4 komplett mit dem Füllmaterial 6 umgeben ist.

In diesem Dokument sind folgende Veröffentlichungen zitiert:
[1] DE 102 052 123 A1
[2] DE 200 04 992 U1
[3] DE 297 20 292 U1
[4] DE 297 10 476 U1
[5] WO 2006/058350 A1
[6] WO 2004/068084 A1
[7] JP 07220506

## Patentansprüche

1. Bodenbelags-Flächenverkleidungsstruktur (0),
• mit einer ersten Schicht (1, 21),
• mit einer Vertiefung (2, 22) in der ersten Schicht (1, 21), und
• mit mindestens einem Elektronikmodul (4, 8) in der Vertiefung (2, 22).
• mit einer zweiten Schicht (6, 14) auf dem mindestens einen Elektronikmodul (8), welche zweite Schicht (6-,14) der ersten Schicht (1) gegenüberliegt und das Elektronikmodul (8) abdeckt, wobei die zweite Schicht (6) auf dem mindestens einen Elektronikmodul (8) die Vertiefung (2) vollständig auffüllt, so dass das mindestens eine Elektronikmodul (8) von der zweiten Schicht (6) bedeckt ist, und wobei das Material der ersten Schicht ein Textil oder ein Schaumstoff ist, und
• wobei die zweite Schicht (6) eine Vergussmasse aufweist oder aus einer Vergussmasse besteht,
• mit mindestens einer elektrisch leitfähigen Bahn (7), die auf der ersten Schicht (1) angeordnet ist, wobei das mindestens eine Elektronikmodul (8) elektrische Kontakte (9) aufweist, die auf der mindestens einen elektrisch leitfähigen Bahn (7) angeordnet sind, so dass sie die mindestens eine elektrisch leitfähige Bahn (7) elektrisch kontaktieren.

2. Bodenbelags-Flächenverkleidungsstruktur (0),
• mit einer ersten Schicht (1, 21),
• mit einer Vertiefung (2, 22) in der ersten Schicht (1, 21), und
• mit mindestens einem Elektronikmodul (4, 8) in der Vertiefung (2, 22).
• mit einer zweiten Schicht (6, 14) auf dem mindestens einen Elektronikmodul (8), welche zweite Schicht (6-,14) der ersten Schicht (1) gegenüberliegt und das Elektronikmodul (8) abdeckt, wobei die zweite Schicht (6) auf dem mindestens einen Elektronikmodul (8) die Vertiefung (2) vollständig auffüllt, so dass das mindestens eine Elektronikmodul (8) von der zweiten Schicht (6) bedeckt ist, und wobei das Material der ersten Schicht ein Textil oder ein Schaumstoff ist, und
• wobei die zweite Schicht (6) eine Vergussmasse aufweist oder aus einer Vergussmasse besteht,
• mit mindestens einer elektrisch leitfähigen Bahn (7), die auf der zweiten Schicht (6, 14) angeordnet ist und das mindestens eine Elektronikmodul (8) kontaktiert.

3. Bodenbelags-Flächenverkleidungsstruktur (0) gemäß einem der Ansprüche 1 oder 2,
wobei das mindestens eine Elektronikmodul (8) auf der mindestens einen elektrisch leitfähigen Bahn (7) angeordnet ist, so dass es diese kontaktiert.

4. Bodenbelags-Flächenverkleidungsstruktur (0) gemäß einem der Ansprüche 1 bis 3, wobei die erste Schicht (1) in einem Bereich (3) des mindestens einen Elektronikmoduls (8) verdichtet ist.

5. Bodenbelags-Flächenverkleidungsstruktur (0) gemäß einem der Ansprüche 1 bis 4, wobei das mindestens eine Elektronikmodul (8) mit einem Klebematerial (5) auf der ersten Schicht (1) und/oder der zweiten Schicht (6) aufgeklebt ist.

6. Bodenbelags-Flächenverkleidungsstruktur (0) gemäß einem der Ansprüche 1 bis 5, wobei das mindestens eine Elektronikmodul (8) mit einem elektrisch nichtleitfähigen Klebematerial (5) auf der ersten Schicht (1) und/oder der zweiten Schicht (6) aufgeklebt ist.

7. Bodenbelags-Flächenverkleidungsstruktur (0) gemäß einem der Ansprüche 1 bis 6, wobei die zweite Schicht (6) elektrisch isolierendes Material aufweist oder aus einem elektrisch isolierenden Material besteht.

8. Bodenbelags-Flächenverkleidungsstruktur (0) gemäß einem der Ansprüche 1 bis 7, mit einer Schutzschicht (11), welche auf der dem mindestens einen Elektronikmodul (8) gegenüberliegenden Seite der ersten Schicht (1) aufgebracht ist.

9. Verfahren zum Herstellen einer Flächenverkleidungsstruktur (0),
• bei dem in einer ersten Schicht (1, 21) eine Vertiefung (2,22) eingebracht wird,
• bei dem mindestens ein Elektronikmodul (4, 8) in der Vertiefung (2, 22) angeordnet wird,
• bei dem eine zweite Schicht (6, 14) auf dem mindestens einen Elektronikmodul (8) aufgebracht wird, welche zweite Schicht (6, 14) der ersten Schicht (1) gegenüberliegt, wobei die zweite Schicht (6, 14) derart auf dem mindestens einen Elektronikmodul (8) aufgebracht wird, dass sie die Vertiefung (2) vollständig auffüllt, so dass das mindestens eine Elektronikmodul von der zweiten Schicht (6) bedeckt ist, und wobei als Material für die erste Schicht (1) Textil oder Schaumstoff verwendet wird, und wobei als Material für die zweite Schicht (6) eine Vergussmasse verwendet wird,
• wobei mindestens eine elektrisch leitfähige Bahn (7) auf der ersten (1) und/oder der zweiten Schicht (14) aufgebracht wird, und
• wobei die elektrischen Kontakte des Elektronikmoduls (8) auf der mindestens einen elektrisch leitfähigen Bahn (7) derart angeordnet werden, dass sie die mindestens eine elektrisch leitfähige Bahn (7) elektrisch kontaktieren.

10. Verfahren gemäß Anspruch 9, wobei die Vertiefung (2) in die erste Schicht (1) unter erhöhter Temperatur eingebracht wird.

11. Verfahren gemäß einem der Ansprüche 9 oder 10, wobei die Vertiefung (2) mittels eines Stempels gebildet wird.

12. Verfahren gemäß einem der Ansprüche 9 bis 11, wobei die Herstellungsschritte im Rahmen eines Rolle-zu-Rolle-Verfahrens durchgeführt werden.

## Claims

1. Pavement surface covering structure (0),
• with a first layer (1, 21),
• with a recess (2, 22) in the first layer (1, 21), and
• with at least an electronic module (4, 8) in the recess (2, 22),
• with a second layer (6, 14) on the at least one electronic module (8), which second layer (6-, 14) faces the first layer (1) and covers the electronic module (8), wherein the second layer (6) on the at least one electronic module (8) completely fills the recess (2), so that the at least one electronic module (8) is covered by the second layer (6), and wherein the material of the first layer is a textile or a foam material, and
• wherein the second layer (6) comprises a potting compound or consists of a potting compound,
• with at least an electrically conductive track (7), which is arranged on the first layer (1), wherein the at least one electronic module (8) comprises electrical contacts (9), which are arranged on the at least one electrically conductive track (7), so that they electrically contact the at least one electrically conductive track (7).

2. Pavement surface covering structure (0),
• with a first layer (1, 21),
• with a recess (2, 22) in the first layer (1, 21), and
• with at least an electronic module (4, 8) in the recess (2, 22),
• with a second layer (6, 14) on the at least one electronic module (8), which second layer (6-, 14) faces the first layer (1) and covers the electronic module (8), wherein the second layer (6) on the at least one electronic module (8) completely fills the recess (2), so that the at least one electronic module (8) is covered by the second layer (6), and wherein the material of the first layer is a textile or a foam material, and
• wherein the second layer (6) comprises a potting compound or consists of a potting compound,
• with at least one electrically conductive track (7), which is arranged on the second layer (6, 14) and contacts the at least one electronic module (8).

3. Pavement surface covering structure (0) according to one of the claims 1 or 2, wherein the at least one electronic module (8) is arranged on the at least one electrically conductive track (7), so that it contacts the same.

4. Pavement surface covering structure (0) according to one of the claims 1 to 3, wherein the first layer (1) is compressed in an area (3) of the at least one electronic module (8).

5. Pavement surface covering structure (0) according to one of the claims 1 to 4, wherein the at least one electronic module (8) is affixed on the first layer (1) and/or the second layer (6) with an adhesive material (5).

6. Pavement surface covering structure (0) according to one of the claims 1 to 5, wherein the at least one electronic module (8) is affixed on the first layer (1) and/or the second layer (6) with an electrically non-conductive adhesive material (5).

7. Pavement surface covering structure (0) according to one of the claims 1 to 6, wherein the second layer (6) comprises electrically insulating material or consists of an electrically insulating material.

8. Pavement surface covering structure (0) according to one of the claims 1 to 7, with a protective layer (11), which is applied on the side of the first layer (1) facing the at least one electronic module (8).

9. Process for producing a surface covering structure (0),
• in which a recess (2, 22) is introduced in a first layer (1, 21),
• in which at least an electronic module (4, 8), is arranged in the recess (2, 22),
• in which a second layer (6, 14) is applied on the at least one electronic module (8), which second layer (6, 14) faces the first layer (1), wherein the second layer (6, 14) is applied on the at least one electronic module (8) in such a way that it completely fills the recess (2), so that the at least one electronic module is covered by the second layer (6), and wherein textile or foam material is used as material for the first layer (1), and wherein a potting compound is used as material for the second layer (6),
• wherein at least an electrically conductive track (7) is applied on the first (1) and/or the second layer (14), and
• wherein the electrical contacts of the electronic module (8) are arranged on the at least one electrically conductive track (7) in such a way that they electrically contact the at least one electrically conductive track (7).

10. Process according to claim 9, wherein the recess (2) is introduced in the first layer (1) under elevated temperature.

11. Process according to one of the claims 9 or 10, wherein the recess (2) is formed by means of a stamp.

12. Process according to one of the claims 9 to 11, wherein the manufacturing steps are carried out in the framework of a roll-to-roll process.

## Revendications

1. Structure de revêtement de surface de revêtement de sol (0),
• avec une première couche (1, 21),
• avec une cavité (2, 22) dans la première couche (1, 21) et
• avec au moins un module électronique (4, 8) dans la cavité (2, 22),
• avec une deuxième couche (6, 14) sur l'au moins un module électronique (8), cette deuxième couche (6-, 14) faisant face à la première couche (1) et recouvrant le module électronique (8), la deuxième couche (6) sur l'au moins un module électronique (8) remplissant entièrement la cavité (2), de façon à ce que l'au moins un module électronique (8) soit recouvert par la deuxième couche (6) et le matériau de la première couche étant un textile ou une mousse et
• la deuxième couche (6) comprenant une masse de scellement ou étant constituée d'une masse de scellement,
• avec au moins une piste électro-conductrice (7), qui est disposée sur la première couche (1), l'au moins un module électronique (8) comprenant des contacts électriques (9) qui sont disposés sur l'au moins une piste électro-conductrice (7), de façon à être en contact électrique avec l'au moins une piste électro-conductrice (7).

2. Structure de revêtement de surface de revêtement de sol (0),
• avec une première couche (1, 21),
• avec une cavité (2, 22) dans la première couche (1, 21) et
• avec au moins un module électronique (4, 8) dans la cavité (2, 22),
• avec une deuxième couche (6, 14) sur l'au moins un module électronique (8), cette deuxième couche (6-, 14) faisant face à la première couche (1) et recouvrant le module électronique (8), la deuxième couche (6) sur l'au moins un module électronique (8) remplissant entièrement la cavité (2), de façon à ce que l'au moins un module électronique (8) soit recouvert par la deuxième couche (6) et le matériau de la première couche étant un textile ou une mousse et
• la deuxième couche (6) comprenant une masse de scellement ou étant constituée d'une masse de scellement,
• avec au moins une piste électro-conductrice (7), qui est disposée sur la deuxième couche (6, 14) et qui est en contact électrique avec l'au moins un module électronique (8).

3. Structure de revêtement de surface de revêtement de sol (0) selon l'une des revendications 1 ou 2,
l'au moins un module électronique (8) étant disposé sur l'au moins une piste électro-conductrice (7), de façon à être en contact électrique avec celle-ci.

4. Structure de revêtement de surface de revêtement de sol (0) selon l'une des revendications 1 à 3, la première couche (1) étant comprimée dans une zone (3) de l'au moins un module électronique (8).

5. Structure de revêtement de surface de revêtement de sol (0) selon l'une des revendications 1 à 4, l'au moins un module électronique (8) étant collé avec un matériau adhésif (5) sur la première couche (1) et/ou la deuxième couche (6).

6. Structure de revêtement de surface de revêtement de sol (0) selon l'une des revendications 1 à 5, l'au moins un module électronique (8) étant collé avec un matériau adhésif non électro-conducteur (5) sur la première couche (1) et/ou la deuxième couche (6).

7. Structure de revêtement de surface de revêtement de sol (0) selon l'une des revendications 1 à 6, la deuxième couche (6) comprenant un matériau électriquement isolant ou étant constituée d'un matériau électriquement isolant.

8. Structure de revêtement de surface de revêtement de sol (0) selon l'une des revendications 1 à 7, avec une couche de protection (11), qui est appliquée sur le côté de la première couche (1) opposée à l'au moins un module électronique (8).

9. Procédé de fabrication d'une structure de revêtement de surface (0),
• dans lequel, dans une première couche (1, 21), une cavité (2, 22) est réalisée,
• dans lequel au moins un module électronique (4, 8) est disposé dans la cavité (2, 22),
• dans lequel une deuxième couche (6, 14) est appliquée sur l'au moins un module électronique (8), cette deuxième couche (6, 14) faisant face à la première couche (1), la deuxième couche (6, 14) étant appliquée sur l'au moins un module électronique (8) de façon à remplir entièrement la cavité (2), de façon à ce que l'au moins un module électronique soit recouvert par la deuxième couche (6) et le matériau utilisé pour la première couche (1) étant un textile ou une mousse et le matériau utilisé pour la deuxième couche (6) étant une masse de scellement,
• au moins une piste électro-conductrice (7) étant appliquée sur la première (1) et/ou la deuxième couche (14) et
• les contacts électriques du module électronique (8) étant disposés sur l'au moins une piste électro-conductrice (7) de façon à être en contact électrique avec l'au moins une piste électro-conductrice (7).

10. Procédé selon la revendication 9, la cavité (2) étant appliquée dans la première couche (1) à haute température.

11. Procédé selon l'une des revendications 9 ou 10, la cavité (2) étant formée au moyen d'un poinçon.

12. Procédé selon l'une des revendications 9 à 11, les étapes de fabrication étant exécutées dans le cadre d'un procédé de rouleau à rouleau.
